# EUROPEAN PATENT APPLICATION

(11) **EP 4 776 833 A1**
(43) Date of publication of application: **15.07.2026**
(21) Application number: 26150872.5
(22) Date of filing: 08.01.2026
(51) Int. Cl.: H10W 40/20

(54) **THERMAL MANAGEMENT ASSEMBLIES FOR SLIDING APPLICATIONS**

(30) Priority: 10.01.2025 US 202563743959 P; 05.01.2026 US 202619439750; 07.01.2026 WO PCT/US2026/010479
(71) Applicant: Laird Technologies, Inc., Chesterfield, MO 63017 (US)
(72) Inventor: WEGRZYNIAK, Pawel, Chesterfield, 63017 (US)
(74) Representative: Lind Edlund Kenamets Intellectual Property AB

(57) **Abstract**

Exemplary embodiments are disclosed of thermal management assemblies or thermal solutions (*e.g.,* with improved durability, *etc.*) for sliding applications. In exemplary embodiments, the thermal management assembly or thermal solution is robust and improves heat transfer between a slidable heat source and a stationary heat sink via a durable layer (*e.g*., metal wear-resistant layer defined by a stainless steel, copper, beryllium copper, aluminum, brass, other metal substrate or cover, other materials with high thermal conductivity and puncture resistant in addition to wear-resistant, *etc.*) disposed over or along a thermal interface material (broadly, interface material) (*e.g.,* thermal phase change material (PCM), *etc.*)*,* thereby providing a durable, slide-resistant thermal interface material (TIM) with improved performance over conventional thermal solutions.

## Description

### FIELD

The present disclosure generally relates to thermal management assemblies and solutions (*e.g.,* with improved durability, *etc*.) for sliding applications.

### BACKGROUND

This section provides background information related to the present disclosure which is not necessarily prior art.

Electrical components, such as semiconductors, integrated circuit packages, transistors, *etc.,* typically have pre-designed temperatures at which the electrical components optimally operate. Ideally, the pre-designed temperatures approximate the temperature of the surrounding air. But the operation of electrical components generates heat. If the heat is not removed, the electrical components may then operate at temperatures significantly higher than their normal or desirable operating temperature. Such excessive temperatures may adversely affect the operating characteristics of the electrical components and the operation of the associated device.

To avoid or at least reduce the adverse operating characteristics from the heat generation, the heat should be removed, for example, by conducting the heat from the operating electrical component to a heat sink. The heat sink may then be cooled by conventional convection and/or radiation techniques. During conduction, the heat may pass from the operating electrical component to the heat sink either by direct surface contact between the electrical component and heat sink and/or by contact of the electrical component and heat sink surfaces through an intermediate medium or thermal interface material (TIM). The thermal interface material may be used to fill the gap between thermal transfer surfaces, in order to increase thermal transfer efficiency as compared to having the gap filled with air, which is a relatively poor thermal conductor.

### DRAWINGS

The drawings described herein are for illustrative purposes only of selected embodiments and not all possible implementations and are not intended to limit the scope of the present disclosure.

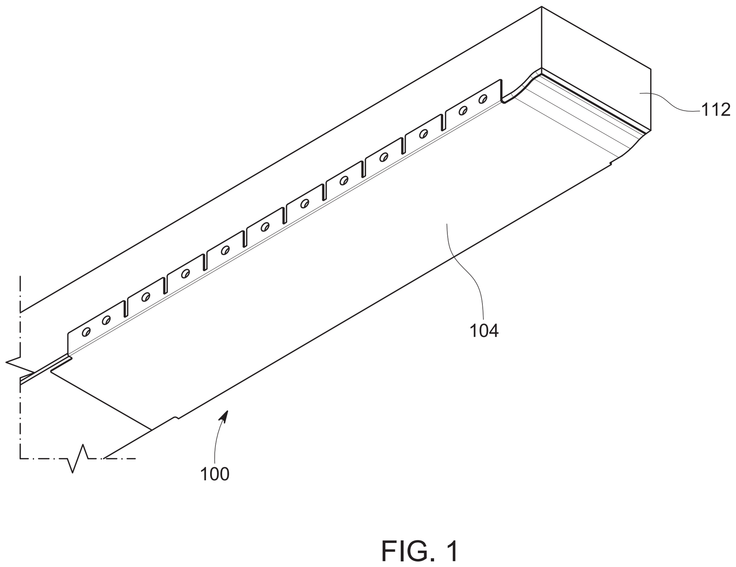

FIG. 1 illustrates an exemplary embodiment of a thermal management assembly or thermal solution including a metal wear-resistant layer (broadly, a durable layer) (*e.g*., stainless steel substrate, other metal substrate, *etc*.) and a thermal interface material (TIM) (broadly, an interface material) (*e.g.,* thermal phase change material (PCM), *etc*.) underneath the metal wear-resistant layer, which thereby improves durability of the TIM.

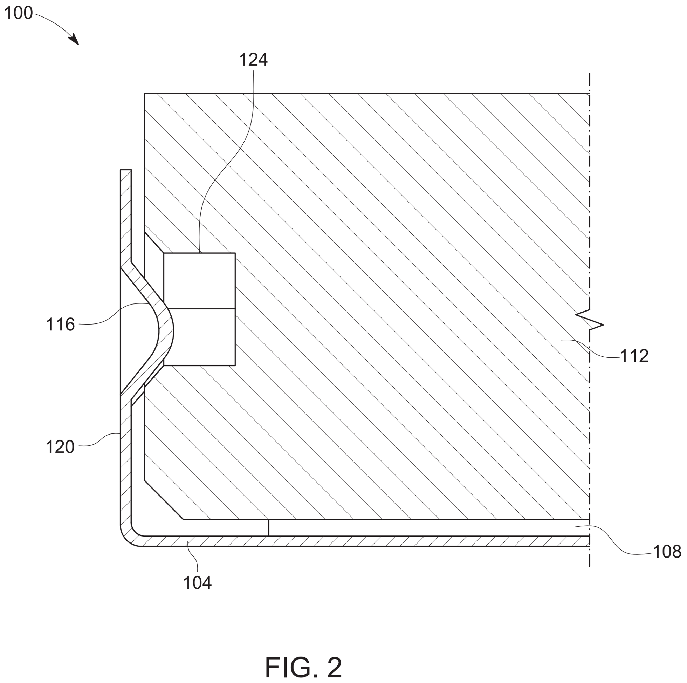

FIG. 2 is a partial cross-sectional view illustrating the thermal interface material (TIM) (broadly, interface material) (*e.g*., thermal phase change material (PCM), *etc*.) positioned underneath the metal wear-resistant layer according to the exemplary embodiment of FIG. 1. The metal wear-resistant layer improves durability of the TIM between a slidable heat source and a stationary heat sink such as when the heat source is slid (*e.g.,* during insertion, removal, and reinsertion, *etc*.) relative to the heat sink along and in physical sliding contact with the metal wear-resistant layer.

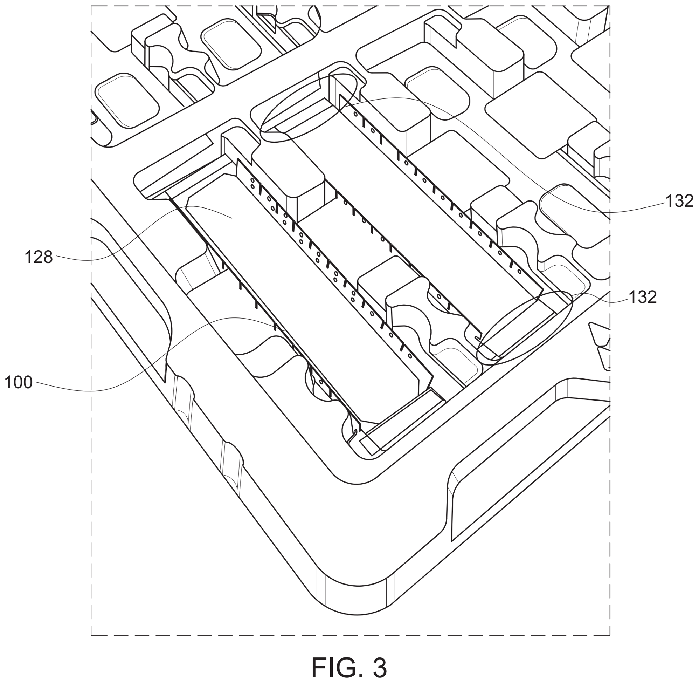

FIG. 3 illustrates a removable protective liner (*e.g.,* protective foil, *etc*.) disposed over the thermal interface material according to the exemplary embodiment of FIG. 1. FIG. 3 also illustrates first and second strips or lines of adhesive material (*e.g.*, pressure sensitive adhesive, *etc*.) adjacent opposing first and second (or front and back) end portions of the protective liner that is disposed over the TIM.

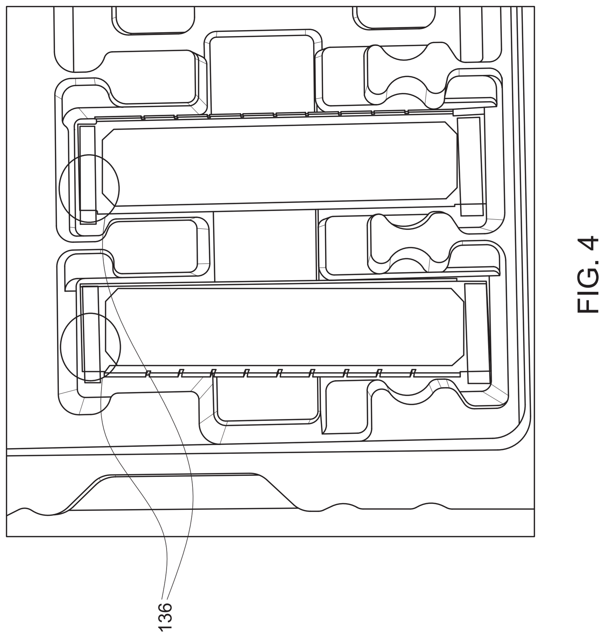

FIG. 4 illustrates exemplary tabs configured to facilitate removal of the removable protective liner (*e.g.,* protective foil, *etc*.) that is disposed over the thermal interface material according to the exemplary embodiment of FIG. 1.

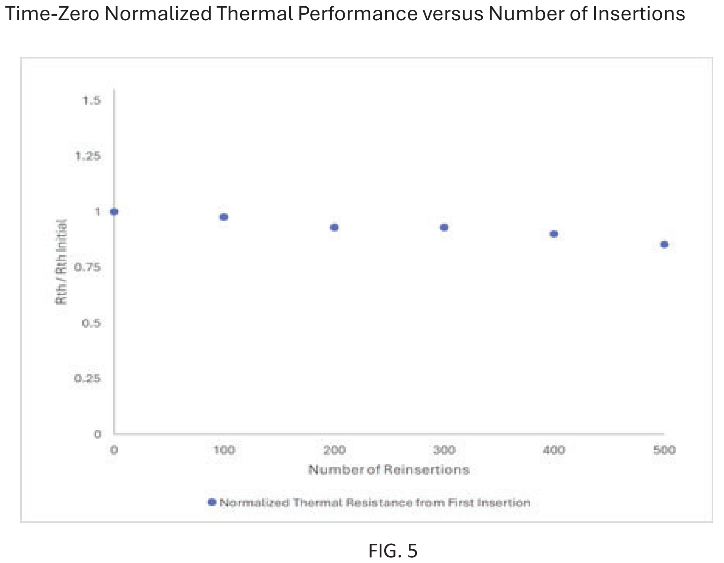

FIG. 5 is a chart of time-zero normalized thermal resistance (Rth/Rth Initial) from first insertion versus number of reinsertions for a thermal management assembly or thermal solution including a metal wear-resistant layer (broadly, a durable layer) (*e.g*., stainless steel substrate, other metal substrate, *etc*.) and a thermal interface material (TIM) (broadly, interface material) (*e.g.,* thermal phase change material (PCM), *etc*.) underneath the metal wear-resistant layer according to exemplary embodiments of the present disclosure.

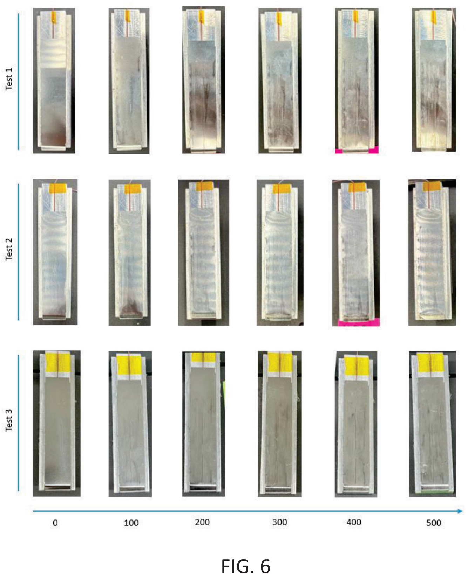

FIG. 6 shows results for three test samples of thermal management assemblies or thermal solutions each including a metal wear-resistant layer (broadly, a durable layer) (*e.g.,* stainless steel substrate, other metal substrate, *etc*.) and a thermal interface material (TIM) (broadly, interface material) (*e.g.,* thermal phase change material (PCM), *etc*.) underneath the metal wear-resistant layer according to exemplary embodiments of the present disclosure. Each sample was visually inspected after every 100 insertions through 500 insertions. No tearing was observed after severe insertion cycling as shown in FIG. 6.

Corresponding reference numerals may indicate corresponding (but not necessarily identical) parts throughout the several views of the drawings.

### DETAILED DESCRIPTION

Example embodiments will now be described more fully with reference to the accompanying drawings.

Exemplary embodiments are disclosed of thermal management assemblies or thermal solutions for sliding applications. In exemplary embodiments, the thermal management assembly or thermal solution is robust and improves heat transfer between a slidable heat source and a stationary heat sink via a durable layer (*e.g*., metal wear-resistant layer defined by a stainless steel, copper, beryllium copper, aluminum, brass, other metal substrate or cover, other materials with high thermal conductivity and puncture resistant in addition to wear-resistant, *etc*.) disposed over or along a thermal interface material (broadly, interface material) (*e.g*., thermal phase change material (PCM), *etc*.), thereby providing a durable, slide-resistant thermal interface material (TIM) with improved performance over conventional thermal solutions.

In exemplary embodiments, a thermal interface material (TIM) assembly (broadly, thermal management assembly or thermal solution) is installed on a heat sink (broadly, heat removal/dissipation structure). The TIM assembly includes a wear-resistant metal layer (broadly, a durable layer) (*e.g.,* stainless steel, other metal, *etc*.) over and/or along a thermal interface material (broadly, an interface material) (*e.g*., thermal phase change material (PCM), *etc*.). The wear-resistant metal layer preserves the TIM as the heat source slides in and out of position relative to the TIM assembly and heat sink. The wear-resistant metal layer may have a thickness within a range from about 17.5 microns to about 300 microns. The thermal interface material applied to the inside of the wear-resistant metal layer may have a thermal conductivity within a range from about 1 Watt per meter-Kelvin (W/m-K) to about 50 W/m-K.

When the heat source is slidably inserted into position relative to the TIM assembly, heat may be conducted along a heat transfer path defined through the wear-resistant metal layer, the TIM layer, and into the heat sink. The TIM assembly may be held in place relative to the heat sink by a series of notches, dimples (or other similar self-locking, retention, latching, snap-latching mechanisms used for retaining a shielding cover to a frame/fence of a board level shield (BLS), *etc*.), and sections of adhesive. The notch-dimple design (or other suitable attachment means/mechanisms) allows for quick and simple alignment during installation while also accounting for necessary flexing to conform or mold to the heat source's surface topology.

As disclosed herein, the metal wear-resistant layer (*e.g*., stainless steel or other metal substrate or cover, *etc*.) may include dimples or bumps (broadly, inwardly protruding portions, protrusions or retention members) along spaced-apart fingers (*e.g*., resilient spring fingers, *etc*.). The dimples or bumps are configured to be engagingly received, retained, latched, or locked within notches or sockets (broadly, openings or recesses) along corresponding fingers of the heat sink, *e.g.,* by pressing the TIM assembly onto the heat sink, *etc.* The engagement of the dimples or bumps of the metal wear-resistant layer within the notches or sockets of the heat sink helps to align and retain the TIM assembly to the heat sink. After the engagement of the dimples or bumps of the metal wear-resistant layer within the notches or sockets of the heat sink, heat may be applied to the TIM assembly, *e.g.,* for setting the TIM, curing the TIM (*e.g.,* via a chemical reaction during the heating process, *etc*.), TIM melt-in, TIM burn-in, phase change of the TIM, softening of the TIM, causing the TIM to become thinner and/or wet a surface, *etc.*

Advantageously, the use of a stainless steel or other metal wear-resistant layer to protect a thermal interface material (broadly, interface material) provides increased durability as compared to polyimide film, which may be susceptible to tearing. Also, the use of a stainless steel or other metal wear-resistant layer to protect the interface material also improves thermal performance over a conventional thermal solution in which a polyimide film is used to provide a wear-resistant layer to protect the thermal interface material. And manufacturability is improved due to the easier alignment and placement during assembly provided by the use of dimples or bumps (broadly, inwardly protruding portions, protrusions, or retention members) along spaced-apart fingers (*e.g.,* resilient spring fingers, *etc*.) that are configured to be engagingly received, retained, latched, or locked within notches or sockets (broadly, openings or recesses) along corresponding fingers of the heat sink.

With reference now to the figures, FIGS. 1 through 4 illustrate an exemplary embodiment of a thermal management assembly 100 or thermal solution including a metal wear-resistant layer 104 (broadly, a durable layer) (e.g. stainless steel substrate, other metal substrate, *etc*.) and a thermal interface material (TIM) 108 (broadly, interface material) (*e.g.,* thermal phase change material (PCM), *etc*.) underneath the metal wear-resistant layer 104. The metal wear-resistant layer 104 improves durability of the thermal interface material 108 between a slidable heat source and heat sink 112 such as when the heat source is slid (*e.g.,* during insertion, removal, reinsertion, *etc*.) relative to the heat sink112 along and in physical sliding contact with the metal wear-resistant layer 104.

In FIG. 1, the thermal management assembly 100 is shown mounted onto a pedestal of a heat sink 112. Alternatively, the thermal management assembly 100 may be mounted differently, *e.g.,* mounted to a different heat sink, mounted to a different heat removal/heat dissipation component, mounted to a heat source or other component, *etc.*

The metal wear-resistant layer 104 includes dimples or bumps 116 (broadly, inwardly protruding portions, protrusions, or retention members) along spaced-apart fingers 120 (*e.g.,* resilient spring fingers, *etc*.) (broadly, sidewall portions). The dimples or bumps 116 are configured to be engagingly received, retained, latched, or locked within notches or sockets 124 (broadly, openings or recesses) along corresponding fingers (broadly, sidewall portions) of the heat sink 112, *e.g.,* by pressing the thermal management assembly 100 onto the heat sink 112, *etc..* The engagement of the dimples or bumps 116 of the metal wear-resistant layer 104 within the notches or sockets 124 of the heat sink 112 helps to align and retain the thermal management assembly 100 to the heat sink 112. After the engagement of the dimples or bumps 116 of the metal wear-resistant layer 104 within the notches or sockets 124 of the heat sink 112, heat may be applied to the thermal management assembly 100, *e.g.,* for setting the thermal interface material 108, curing the thermal interface material 108 (*e.g.,* via a chemical reaction during the heating process, *etc*.), TIM melt-in, TIM burn-in, phase change of the thermal interface material 108, softening of the thermal interface material 108, causing the thermal interface material 108 to become thinner and/or wet a surface, *etc.*

Alternative embodiments may be configured differently than what is shown in the figures. For example, another exemplary embodiment may include a stainless steel substrate that defines the wear-resistant layer wherein the stainless steel substrate does not include any dimples or bumps along spaced-apart fingers that are configured to be engagingly received, retained, latched, or locked within notches or sockets along corresponding fingers of a heat sink. Other exemplary embodiments may include metal wear-resistant layers that have other suitable means, mechanisms, or features (*e.g*., detents, full-dimples, half-dimples, non-circular dimples, latches, other means by which a board level shielding (BLS) cover is attached to a frame/fence *etc*.) for aligning and attaching the assembly to the heat sink instead of or in addition to the dimples or bumps of the wear-resistant layer and the notches or sockets of the heat sink.

FIG. 2 illustrates the thermal interface material (TIM) 108 (broadly, interface material) (*e.g.,* thermal phase change material (PCM), *etc*.) positioned underneath the metal wear-resistant layer 104 according to the exemplary embodiment of FIG. 1. The metal wear-resistant layer 104 improves durability of the thermal interface material 108 between a slidable heat source and heat sink 112 such as when the heat source is slid (*e.g*., during insertion, removal, reinsertion, *etc*.) relative to the heat sink 112 along and in physical sliding contact with the metal wear-resistant layer 104.

FIG. 3 illustrates a removable protective liner 128 (*e.g.,* protective foil, *etc*.) disposed over the thermal interface material 108 of the thermal management assembly 100 according to the exemplary embodiment of FIG. 1. FIG. 3 also illustrates first and second strips or lines of adhesive material 132 (*e.g.,* pressure sensitive adhesive, *etc*.) adjacent opposing first and second (or front and back) portions of the protective liner 128 that is disposed over the thermal interface material 108 of the thermal management assembly 100. The thermal interface material 108 is within a channel or area defined generally between the first and second strips of adhesive material 132. FIG. 4 illustrates exemplary tabs 136 configured to facilitate removal of the removable protective liner 128 (*e.g.,* protective foil, *etc*.) disposed over the thermal interface material 108 of the thermal management assembly 100 according to the exemplary embodiment of FIG. 1.

The first and second strips of adhesive material 132 may be configured to provide reinforcement along the front and back edge portions of the thermal interface material 108 that are perpendicular to a sliding direction between the slidable heat source and the heat sink 112 (broadly, heat removal/dissipation structure) to which the thermal management assembly 100 is coupled (*e.g*., adhesively attached, attached by engagement of dimples/bumps within notches/sockets, *etc*.). The fingers 120 (broadly, sidewall portions) of the metal wear-resistant layer 104 may be configured to provide reinforcement along the side edge portions of the thermal interface material 108 that are parallel to a sliding direction between the slidable heat source and the heat sink 112 (broadly, heat removal/dissipation structure) to which the Assembly 100 is coupled (*e.g*., adhesively attached, attached by engagement of dimples/bumps within notches/sockets, *etc*.). The reinforcement along the edge portions of the thermal interface material 108 may absorb compression forces and help confine the thermal interface material 108 within a channel or area defined generally between the first and second strips of adhesive material 132, thereby helping to maintain integrity of and inhibit migration of the thermal interface material 108

The first and second strips or lines of adhesive material 132 may comprise first and second layers or coatings of pressure sensitive adhesive along opposite first and second sides of a polymer film (*e.g*., polyethylene terephthalate film, thermoplastic polymer film, organic heat spreader film, a flame-resistant meta-aramid film, other aramid film, *etc*.). For example, the first and second strips or lines of adhesive material 132 may comprises first and second layers or coatings of pressure sensitive adhesive along opposite first and second sides of a polyethylene terephthalate film. In this latter example, the polyethylene terephthalate film may have a thickness of about 50 microns, and the pressure sensitive adhesive may have a thickness of about 25 microns along each side of the polyethylene terephthalate film.

As another example, the first and second strips or lines of adhesive material may comprise an organic heat spreader including a polymer film coated with a thermally-conductive pressure-sensitive adhesive. The organic heat spreader may be configured to have high thermal conductivity (*e.g.,* in-plane thermal conductivity of about 50 W/m-K, *etc*.) within the plane of the film that is higher than the through-plane thermal conductivity (*e.g.,* about 0.2 W/m-K, *etc*.), and a high resistivity (*e.g.,* greater than 1015 Watts per centimeter (W/cm), *etc*.). The first and second strips or lines of adhesive material may comprise a pressure sensitive adhesive having a thickness within a range from about 25 microns to about 200 microns (*e.g*., 25 microns, 80 microns, 100 microns, 125 microns, 140 microns, 150 microns, 160 microns, *etc*.).

In exemplary embodiments, the thermal interface material, the metal wear-resistant layer, and the first and second strips or lines of adhesive material are not slidable relative to each other. Instead, the positions of the thermal interface material, the metal wear-resistant layer, and the first and second strips or lines of adhesive material may be fixed relative to each other.

A wide range of materials may be used for the durable layer in exemplary embodiments, such as stainless steel (*e.g*., 301/302 stainless steel, *etc*.), phosphor bronze, copper-clad steel, brass, monel, nickel silver alloys, aluminum, aluminum alloys, steels, carbon steel, cold rolled steel, sheet metal, brass, copper, copper nickel alloys, beryllium copper alloys, other copper based alloys, alloys of magnesium, other metals, other alloys, other materials with high thermal conductivity and puncture resistant in addition to wear-resistant, materials having higher thermal conductivity than polyimide film and that more durable (*e.g*., puncture resistant and wear resistant) than polyimide film, *etc.* Aspects of the present disclosure should not be limited to use with any one particular durable layer or metal wear-resistant layer as exemplary embodiments may include a wide range of metals, metal alloys, and other materials that are used for providing a durable layer (*e.g.,* puncture resistant and wear resistant layer, *etc*.).

A wide range of materials may be used for the interface material, such as a thermal gap filler, thermal phase change material, thermally-conductive EMI absorber or hybrid thermal/EMI absorber, thermal putty, thermal pad, thermal grease, other thermal interface materials disclosed herein, *etc.* In exemplary embodiments, the interface material comprises a thermal phase change material having a thermal conductivity within a range from about 1 W/m-K to about 50 W/m-K. For example, the interface material may comprise a thermal phase change material having a thermal conductivity of about 7.5 W/m-K. The interface material may be naturally tacky and/or self-adherent to another surface of a component. The interface material may be softer, more compliant, less durable, and/or more susceptible to abrasion than the metal wear-resistant layer. As disclosed herein, the thermal management assemblies or thermal solutions may provide the interface materials with sufficiently good durability and abrasion resistance, thereby allowing the interface materials to survive and/or withstand sliding operations. Aspects of the present disclosure should not be limited to use with any one particular interface material as exemplary embodiments may include a wide range of thermal interface materials and other interface materials.

In exemplary embodiments, the thermal management assembly 100 shown in FIG. 1 may be assembled onto a heat sink 112, heat source, or other component via the following exemplary process. The assembly process may include removing or peeling off the protective liner 128 (*e.g.,* protective foil, *etc*.) thereby exposing the thermal interface material 108 (broadly, interface material). After the protective liner 128 has been removed, the thermal management assembly 100 may be positioned on the heat sink 112, heat source, or other component such that the thermal interface material 108 thermally contacts (*e.g*., makes direct physical contact with, is compressed against, *etc*.) the heat sink 112, heat source, or other component. Positioning the thermal management assembly 100 on the heat sink 112, heat source, or other component may also include the dimples or bumps 116 along the fingers 120 of the metal substrate 104 of the thermal management assembly 100 being engagingly received, retained, latched, or locked within the notches or sockets 124 along corresponding fingers of the heat sink 112, heat source, or other component, *e.g.,* by pressing the thermal management assembly 100 onto the heat sink 112, heat source, or other component, *etc.* The engagement of the dimples or bumps 116 of the metal substrate 104 within the notches or sockets 124 of the heat sink 112, heat source, or other component helps to align and retain the thermal management assembly 100 to the heat sink 112, heat source, or other component. After the engagement of the dimples or bumps 116 of the metal substrate 104 within the notches or sockets 124 of the heat sink 112, heat source, or other component, heat may be applied to the thermal management assembly 100, *e.g.,* for setting the thermal interface material 108, curing the thermal interface material 108 (e*.g.,* via a chemical reaction during the heating process, *etc*.), TIM melt-in, TIM burn-in, phase change of the thermal interface material 108, softening of the thermal interface material 108, causing the thermal interface material 108 to become thinner and/or wet a surface, *etc.*

The use of a metal substrate (*e.g*., stainless steel, copper, beryllium copper, aluminum, brass, nickel, nickel plating, chrome plating, and/or non-metal film bonded to metal or metalized, *etc*.) defining a durable layer (*e.g.,* puncture resistant and wear-resistant layer over or along a thermal interface material (TIM) improves heat transfer between a slidable heat source and heat sink as compared to a conventional solution that uses a polyimide film to define a wear-resistant layer over or along a thermal interface material (TIM). The improved thermal performance is due to using higher thermal conductivity components (metal versus polyimide) as compared to the conventional TIM assembly that uses a polyimide film to define the wear-resistant layer.

The thermal management assemblies and thermal solutions disclosed herein may be used with a wide range of devices and components. Accordingly, aspects of the present disclosure are not limited to use with only heat sinks as the thermal management assemblies and thermal solutions disclosed herein may be used with other heat removal/dissipation structures and/or components, *e.g.,* a heat removal/dissipation structure that is part of a housing or cage itself, a heat pipe, a vapor chamber, a heat spreader, a cold plate, *etc.* The thermal management assemblies and thermal solutions disclosed herein may be used with a connector plug, a slidable part of a tablet or other modular portable device, a cage of a transceiver (*e.g*., a small form-factor pluggable (SFP) transceiver, SFP+ transceiver, quad small form-factor pluggable (QSFP) transceiver, QSFP+ transceiver, XFP transceiver, Octal Small Form Factor Pluggable (OSFP) transceivers, *etc*.), any hot-swappable component, E1.2 memory application, E3.s memory application, *etc.*

In exemplary embodiments, a thermal management assembly is configured to improve heat transfer between a slidable heat source and heat sink via a durable layer disposed over and/or along a thermal interface material, thereby providing a durable, slide-resistant thermal interface material with improved performance.

In exemplary embodiments, a thermal management assembly comprises a thermal interface material and a durable layer disposed over and/or along the thermal interface material. The durable layer is configured to preserve the thermal interface material as a heat source or other component slides in and out of position relative to the thermal management assembly.

In exemplary embodiments, a thermal management assembly comprises a substrate having opposite inner and outer surfaces. A thermal interface material is along the inner surface of the substrate. The substrate defines a durable layer that is disposed over and/or along the thermal interface material. The durable layer is configured to slide along and in contact with a first surface of a first component when the thermal management assembly is along a second surface of a second component and when the first and second surfaces are slidably moved relative to each other.

In exemplary embodiments, the substrate comprises a metal substrate. For example, the substrate may comprises a metal such as (but not limited to) stainless steel, copper, beryllium copper, *etc.*

In exemplary embodiments, the durable layer has a higher thermal conductivity than polyimide film and is more wear-resistant and puncture resistant than polyimide film.

In exemplary embodiments, the substrate comprises a metal substrate defining a metal wear-resistant layer that is disposed over and/or along the thermal interface material. The metal wear-resistant layer is configured to slide along and in contact with a first surface of a first component when the thermal management assembly is along a second surface of a second component and when the first and second surfaces are slidably moved relative to each other.

In exemplary embodiments, the thermal management assembly is adhesively attached to the inner surface of the substrate.

In exemplary embodiments, the thermal management assembly is naturally tacky and/or self-adherent such that the thermal interface material is self-adhered to the inner surface of the substrate without requiring an additional adhesive.

In exemplary embodiments, the first component comprises a heat source. The second component comprises a heat sink. And the thermal management assembly is applied to the heat sink such that the thermal interface material is between the heat sink and the durable layer and such that the durable layer is between the thermal interface material and the heat source. The durable layer is configured to slide relatively along and in contact with the heat source when the heat source is slidably moved relative to the heat sink and the thermal management assembly applied to the heat sink.

In exemplary embodiments, the first component comprises a heat sink. The second component comprises a heat source. The thermal management assembly is applied to the heat source such that the thermal interface material is between the heat source and the durable layer and such that the durable layer is between the thermal interface material and the heat sink. The durable layer is configured to slide relatively along and in contact with the heat sink when the heat source (and the thermal management assembly applied to the heat source) is slidably moved relative to the heat sink.

In exemplary embodiments, the durable layer comprises stainless steel. For example, the durable layer may comprise a metal such as (but not limited to) stainless steel, copper, beryllium copper, *etc.*

In exemplary embodiments, the durable layer is wear-resistant and puncture resistant.

In exemplary embodiments, the durable layer has a higher thermal conductivity than polyimide film and is more wear-resistant and puncture resistant than polyimide film.

In exemplary embodiments, the durable layer is a metal wear-resistant layer that is disposed over and/or along the thermal interface material. The metal wear-resistant layer is configured to slide along and in contact with a first surface of a first component when the thermal management assembly is along a second surface of a second component and when the first and second surfaces are slidably moved relative to each other.

In exemplary embodiments, the thermal interface material comprises a thermal phase change material. In other exemplary embodiments, the thermal interface material is not a thermal phase change material.

In exemplary embodiments, the durable layer is configured to preserve the thermal interface material as the heat source slides in and out of position relative to the thermal management assembly and heat sink.

In exemplary embodiments, the durable layer has a thickness within a range from about 17.5 microns to about 300 microns.

In exemplary embodiments, the thermal interface material has a thermal conductivity within a range from about 1 Watt per meter-Kelvin (W/m-K) to about 50 W/m-K.

In exemplary embodiments, the durable layer is defined by a substrate or cover including inwardly protruding portions, protrusions, or retention members along spaced-apart fingers of the substrate or cover that are configured to be engagingly received, retained, latched, or locked within openings, holes, or recesses along a heat sink, heat source, or other component. The substrate or cover may comprise a metal such as (but not limited to) stainless steel, copper, beryllium copper, *etc.*

In exemplary embodiments, a removable protective liner is disposed over the thermal interface material.

In exemplary embodiments, first and second portions of adhesive are respectively adjacent opposite front and back edge portions of the thermal interface material. The first and second portions of adhesive provide reinforcement along the front and back edge portions of the thermal interface material that helps to confine the thermal interface material within an area defined by the reinforcement and thereby inhibits migration of the thermal interface material.

In exemplary embodiments, the thermal interface material comprises at least one of a thermally-conductive pad, a thermally-conductive gap filler, a phase change thermal interface material, a dispensable thermal interface material, a thermal putty, and a thermal grease.

In exemplary embodiments, a device includes a thermal management assembly substantially as disclosed herein, a heat sink, and a heat source slidable relative to the heat sink. The thermal management assembly is applied to the heat sink such that the thermal interface material is between the heat sink and the durable layer and such that the durable layer is between the thermal interface material and the heat source. The durable layer is configured to slide relatively along and in contact with the heat source when the heat source is slidably moved relative to the heat sink and the thermal management assembly applied to the heat sink.

In exemplary embodiments, a device includes a thermal management assembly substantially as disclosed herein, a heat sink, and a heat source slidable relative to the heat sink. The thermal management assembly is applied to the heat source such that the thermal interface material is between the heat source and the durable layer and such that the durable layer is between the thermal interface material and the heat sink. The durable layer is configured to slide relatively along and in contact with the heat sink when the heat source (including the thermal management assembly applied thereto) is slidably moved relative to the heat sink.

Also disclosed are exemplary methods of assembly a thermal management assembly to a heat sink or a heat source substantially as disclosed herein. In exemplary embodiments, the thermal management assembly includes a durable layer disposed over and/or along a thermal interface material.

An exemplary method of installing a sliding thermal management assembly comprises applying a thermal interface material (TIM) (*e.g.,* thermal phase-change material, *etc*.) directly to an inner surface of a metal cover, which also includes an outer sliding surface and spring fingers with inward dimples. The exemplary method further includes applying first and second adhesive reinforcement strips along opposite edges of the thermal interface material that are perpendicular to an intended sliding direction. The exemplary method may also include removing a protective liner from off top of the thermal interface material. The exemplary method may also include pressing the metal cover onto a heat-removal component (*e.g.,* heat sink, *etc*.) such that the inward dimples are received in sockets of the heat-removal component and the thermal interface material contacts the heat-removal component.

In some exemplary methods, the method may further include heating the assembly to a burn-in temperature between 45 °C and 75 °C to soften the thermal interface material and reduce its thickness by 10% to 40%, thereby improving wetting and decreasing contact resistance.

In some exemplary methods, the metal cover may comprise stainless steel and thickness from about 50 microns to 100 microns. Each adhesive reinforcement strip may comprise a PET film having a thickness of 50 microns with 25 micron thick adhesive on each side. The sockets may be formed as notches in a heat sink pedestal. The assembly may be installed into a pluggable transceiver cage such as SFP, SFP+, QSFP, QSFP+, and OSFP.

In exemplary embodiments, a sliding thermal management assembly comprises a metal cover (*e.g.,* stainless steel, copper, beryllium copper, *etc*.) having an outer sliding surface and an inner surface. A thermal interface material is disposed on (*e.g.,* directly on without any intervening components, *etc*.) the inner surface of the metal cover. A plurality of inwardly protruding dimples are formed along spaced-apart spring fingers of the metal cover. The dimples are configured to be received in corresponding sockets of a heat-removal component (*e.g*., a pedestal of a heat sink, *etc*.). First and second adhesive reinforcement strips are positioned on opposite edges of the thermal interface material and extend along edges that are perpendicular to a sliding direction, whereby the thermal interface material is confined between the first and second adhesive reinforcement strips such that, during sliding insertion of a heat source along the outer sliding surface of the metal cover. The first and second adhesive reinforcement strips absorb edge compression and inhibit migration of the thermal interface material. A heat transfer path extends through the metal cover, the thermal interface material, and into the heat-removal component.

In exemplary embodiments, a device comprises a heat sink having sockets along sidewalls of a pedestal. The device also includes a sliding thermal management assembly as disclosed herein. The sliding thermal management assembly is engaged to the heat sink by receipt of the dimples along spaced-apart spring fingers of the metal cover into the sockets along the sidewalls of the pedestal. A heat source is configured to be slid into and out of thermal contact with the outer sliding surface of the metal cover. The metal cover preserves the thermal interface material during repeated sliding insertion and removal cycles and maintains a thermal path from the heat source through the metal cover and the thermal interface material into the heat sink.

In exemplary embodiments, the metal cover may comprise stainless steel and have a thickness from 50 microns to 100 microns. The thermal interface material may comprise a thermal phase-change material having a through-plane thermal conductivity from 5 Watts per meter per Kelvin (W/m-K) to 15 W/m-K. Each of the first and second adhesive reinforcement strips may comprises a polymer film (PET film) with pressure-sensitive adhesive on opposed sides and has a total thickness from 75 microns to 150 microns. The spring fingers may be integral with sidewalls of the metal cover. And the sockets may be formed as notches in a pedestal of a heat sink.

In exemplary embodiments, the heat source may comprise a pluggable transceiver module. The heat sink may comprise a machined aluminum pedestal with the sockets formed as notches. The sliding insertion direction may be parallel to edges reinforced by the spring fingers and perpendicular to edges reinforced by the adhesive strips. And the device may further comprise a cage or housing that provides the sliding alignment.

In exemplary embodiments, cycle durability testing demonstrates that the assembly maintains a sufficient contact resistance (*e.g.,* of ≤0.2 K.cm²/W, *etc*.) after repeated (*e.g.,* at least 500, *etc*.) sliding insertion/removal cycles. Exemplary embodiments may include adhesive reinforcement strips comprising polyethylene terephthalate (PET) film having a thickness of about 50 microns with pressure-sensitive adhesive layers of about 25 microns on each side, for a total thickness of about 100 microns. Exemplary embodiments may include a burn-in process for reducing the TIM's thickness by about 10% to about 40% relative to its pre-burn-in thickness, improving wetting and lowering contact resistance.

In exemplary embodiments, the thermal interface material may comprise a thermal phase-change material having a through-plane thermal conductivity from about 5 W/m·K to about 15 W/m·K, and a melt-in temperature between about 45 °C and about 75 °C.

In exemplary embodiments, the metal wear-resistant layer may consist essentially of stainless steel grade 301 or 302 with a thickness from about 50 microns to about 100 microns, providing a thermal conductivity at least ten times greater than polyimide film of equal thickness. 9.

In exemplary embodiments, the metal cover may comprise a copper-clad steel or beryllium copper alloy. In exemplary embodiments, the dimples may comprise half-dimples having non-circular planform shapes. In exemplary embodiments, the heat-removal component may comprise a heat sink, vapor chamber, or cold plate.

FIG. 5 is a chart of time-zero normalized thermal resistance (Rth/Rth Initial) from first insertion versus number of reinsertions for a test sample of a thermal management assembly or thermal solution including a metal wear-resistant layer (broadly, a durable layer or wear-resistant) (*e.g.,* stainless steel substrate, other metal substrate, *etc*.) and a thermal interface material (TIM) (*e.g.,* thermal phase change material (PCM), *etc*.) underneath the metal wear-resistant layer according to exemplary embodiments of the present disclosure.

For this particular testing, the sample included a stainless steel layer over the thermal interface material (TIM). The purpose of the testing was to characterize the durability and performance of the sample product after 500 reinsertions.

**Test Conditions:** The tests were conducted in a lab setting with the ambient temperature maintained between 20°C and 25°C. The interface load applied to the OSFP-IHS module (Octal Small Form Factor Pluggable (OSFP) Integrated Heat Sink (IHS) module) during testing was 36 Newtons, which is consistent with the guidelines specified in the OSFP MSA Rev 5.1 Section 5.5. The cold plate inlet temperature was set to 20°C.

**Test Preparation:** To burn in the samples, the samples were loaded against a glass plate with known surface flatness less than 50 microns and subjected to the following conditions:
- Pressure: 13.8 kPa (kilopascals);
- Temperature and time: Cold plate maintained at 70°C for 30 minutes; and
- Ensure cold plate is less than 35°C before removing pressure from the interface.

**Test Procedure:**
1. Set liquid loop such that inlet temperature to the cold plate is 20°C.
2. Insert the TTV (thermal test vehicle), characterize thermal resistance prior to reinsertions.
3. Remove and reinsert TTV 100 times by hand.
4. Visually inspect the sample product surface for tears, document surface condition with a picture (*e.g*., see FIG. 6).
5. Characterize thermal resistance.
6. Remove and reinsert TTV 100 times by hand.
7. Repeat Steps 4-6 until 500 insertions have been completed.

**Thermal Performance Results:** Thermal performance was measured at each 100 insertion interval to track whether thermal resistance increased with the number of insertions. Compared to the initial thermal resistance, the thermal resistance after each round of 100 insertions was consistent and even slightly improved by the end of the 500 insertions, *e.g.,*as shown in FIG. 5.

FIG. 6 shows results through 500 insertions for three test samples of thermal management assemblies or thermal solutions each including a metal wear-resistant layer (broadly, a durable layer) (*e.g.,* stainless steel substrate, other metal substrate, *etc*.) and a thermal interface material (TIM) (*e.g.,* thermal phase change material (PCM), *etc*.) underneath the metal wear-resistant layer according to exemplary embodiments of the present disclosure. Each sample was visually inspected after every 100 insertions. No tearing was observed after severe insertion cycling as shown in FIG. 6.

Various aspects of the invention according to the present disclosure include, but are not limited to, the aspects listed in the following numbered clauses.

Clause 1. A thermal management assembly for sliding applications, the assembly comprising: a substrate having opposite inner and outer surfaces; and an interface material along the inner surface of the substrate; wherein the substrate defines a durable layer that is disposed over and/or along the interface material and that is configured to contact a first surface of a first component when the thermal management assembly is along a second surface of a second component and when the first surface is slidably moved relative to the second surface.

Clause 2. The assembly of clause 1, wherein: the substrate comprises a metal cover having an outer sliding surface and an inner surface; the interface material is disposed on the inner surface of the metal cover; a plurality of inwardly protruding dimples are along spaced-apart spring fingers of the metal cover, the dimples configured to be received in corresponding sockets of a heat-removal component; and a heat transfer path extends through the metal cover, the interface material, and into the heat-removal component.

Clause 3. The assembly of clause 2, wherein first and second adhesive reinforcement strips are positioned on opposite edges of the interface material and extend along edges that are perpendicular to a sliding direction, whereby the interface material is confined between the first and second adhesive reinforcement strips such that, during sliding insertion of a heat source along the outer sliding surface of the metal cover, the first and second adhesive reinforcement strips absorb edge compression and inhibit migration of the interface material.

Clause 4. The assembly of clause 3, wherein: the metal cover comprises stainless steel; the interface material comprises a thermal phase-change material; and each of the first and second adhesive reinforcement strips comprises a polymer film with pressure-sensitive adhesive on opposed sides.

Clause 5. The assembly of clause 3, wherein: the metal cover comprises stainless steel having a thickness from 50 microns to 100 microns; the interface material comprises a thermal phase-change material having a through-plane thermal conductivity from 5 Watts per meter per Kelvin (W/m-K) to 15 W/m-K; and each of the first and second adhesive reinforcement strips comprises a polymer film with pressure-sensitive adhesive on opposed sides and has a total thickness from 75 microns to 150 microns.

Clause 6. The assembly of clause 3, wherein: the metal cover comprises stainless steel having a thickness from 6 microns to 200 microns; the interface material comprises a thermal phase-change material having a through-plane thermal conductivity from 0.15 Watts per meter per Kelvin (W/m-K) to 50 W/m-K; and each of the first and second adhesive reinforcement strips comprises a polymer film with pressure-sensitive adhesive on opposed sides and has a total thickness not more than 200 microns.

Clause 7. The assembly of clause 2 or 3, wherein: the metal cover comprises stainless steel having a thickness from 50 microns to 100 microns; and the interface material comprises a thermal phase-change material having a through-plane thermal conductivity from 5 Watts per meter per Kelvin (W/m-K) to 15 W/m-K.

Clause 8. The assembly of clause 2 or 3, wherein: the metal cover comprises stainless steel having a thickness from 6 microns to 200 microns; and the interface material comprises a thermal phase-change material having a through-plane thermal conductivity from 0.15 Watts per meter per Kelvin (W/m-K) to 50 W/m-K.

Clause 9. The assembly of any of clauses 2 to 8, wherein the metal cover has a thermal conductivity at least ten times greater than a polyimide film of equal thickness.

Clause 10. The assembly of any of clauses 2 to 9, wherein: the spring fingers are integral with sidewalls of the metal cover; and the sockets are notches in a pedestal of a heat sink.

Clause 11. The assembly of clause 1, wherein the substrate comprises self-locking features configured to interface and engage with corresponding self-locking features of a heat-removal component to thereby retain the substrate to the heat-removal component.

Clause 12. The assembly of clause 1, wherein the substrate comprises a protruding dimples configured to be received in corresponding sockets of a heat-removal component to thereby retain the substrate to the heat-removal component.

Clause 13. The assembly of clause 1, wherein the substrate comprises a plurality of sockets configured to receive therein protruding dimples a heat-removal component to thereby retain the substrate to the heat-removal component.

Clause 14. The assembly of clause 1, wherein: the substrate comprises a plurality of sockets configured to engagingly receive metal cover having an outer sliding surface and an inner surface; the interface material is disposed on the inner surface of the metal cover; a plurality of inwardly protruding dimples are along spaced-apart spring fingers of the metal cover, the dimples configured to be received in corresponding sockets of a heat-removal component; and a heat transfer path extends through the metal cover, the interface material, and into the heat-removal component.

Clause 15. The assembly of any of clauses 1 to 14, wherein the thickness of the interface material after burn-in is reduced by 10% to 40% relative to a pre burn-in thickness of the interface material.

Clause 16. The assembly of any of clauses 1 to 15, wherein the substrate comprises a metal substrate including stainless steel, copper, or beryllium copper.

Clause 17. The assembly of any of clauses 1 to 16, wherein: the durable layer is wear-resistant and puncture resistant; and the durable layer has a higher thermal conductivity than polyimide film and is more wear-resistant and puncture resistant than polyimide film.

Clause 18. The assembly of any of clauses 1 to 17, wherein: the durable layer is wear-resistant and puncture resistant; and the durable layer has a thermal conductivity, wear-resistance, and/or puncture resistance about the same as or better than polyimide film.

Clause 19. The assembly of any of clauses 1 to 18, wherein the substrate comprises a metal substrate defining a metal wear-resistant layer that is disposed over and/or along the interface material and that is configured to slide along and in contact with the first surface of the first component when the thermal management assembly is along the second surface of the second component and when the first surface is slidably moved relative to the second surface.

Clause 20. The assembly of any of clauses 1 to 19, wherein the interface material is naturally tacky and self-adherent to the inner surface of the substrate without requiring an additional adhesive.

Clause 21. The assembly of any of clauses 1 to 20, wherein: the first component comprises a heat source; the second component comprises a heat sink; and the thermal management assembly is applied to the heat sink such that the interface material is between the heat sink and the durable layer and such that the durable layer is between the interface material and the heat source; and the durable layer is configured to slide relatively along and in contact with the heat source when the heat source is slidably moved relative to the heat sink and the thermal management assembly applied to the heat sink.

Clause 22. The assembly of any of clauses 1 to 20, wherein: the first component comprises a heat sink; the second component comprises a heat source; and the thermal management assembly is applied to the heat source such that the interface material is between the heat source and the durable layer and such that the durable layer is between the interface material and the heat sink; and the durable layer is configured to slide relatively along and in contact with the heat sink when the heat source (and the thermal management assembly applied to the heat source) is slidably moved relative to the heat sink.

Clause 23. The assembly of any of clauses 1 to 22, wherein: the durable layer has a thickness within a range from about 17.5 microns to about 300 microns; and/or the interface material has a thermal conductivity within a range from about 1 W/m-K to about 50 W/m-K.

Clause 24. The assembly of any of clauses 1 to 23, wherein the substrate includes inwardly protruding portions along spaced-apart fingers of the substrate that are configured to be engagingly received within openings along a heat sink, heat source, or other component.

Clause 25. The assembly of any of clauses 1 to 24, further comprising a removable protective liner disposed over the interface material with tear tabs aligned to a sliding direction.

Clause 26. The assembly of any of clauses 1 to 25, further comprising first and second portions of adhesive respectively adjacent opposite front and back edge portions of the interface material, wherein the first and second portions of adhesive provide reinforcement along the front and back edge portions of the interface material that helps to confine the interface material within an area defined by the reinforcement and thereby inhibits migration of the interface material.

Clause 27. The assembly of any of clauses 1 to 26, wherein: the interface material comprises at least one of a thermally-conductive pad, a thermally-conductive gap filler, a dispensable thermal interface material, a phase change thermal interface material, a thermal putty, and a thermal grease; the substrate is configured to preserve the interface material as a heat source or other component slides in and out of position relative to the thermal management assembly; and the thermal management assembly is configured to improve heat transfer between a slidable heat source and heat sink via the substrate defining the durable layer over and/or along the interface material, thereby providing a durable, slide-resistant interface material with improved performance.

Clause 28. The assembly of any of clauses 1 to 27, wherein the substrate preserves the interface material during repeated sliding insertion and removal cycles and maintains a thermal path through the substrate and the interface material.

Clause 29. The assembly of any of clauses 1 to 28, wherein the substrate comprises a portion of an EMI cage for an optical transceiver application that defines the durable layer disposed over and/or along the interface material.

Clause 30. A thermal management assembly for sliding applications, the assembly comprising: a metal cover having an outer sliding surface and an inner surface; an interface material disposed on the inner surface of the metal cover; a plurality of inwardly protruding dimples along spaced-apart spring fingers of the metal cover, the dimples configured to be received in corresponding sockets of a heat-removal component; and first and second adhesive reinforcement strips positioned on opposite edges of the interface material and extend along edges that are perpendicular to a sliding direction, whereby the interface material is confined between the first and second adhesive reinforcement strips such that, during sliding insertion of a heat source along the outer sliding surface of the metal cover, the first and second adhesive reinforcement strips absorb edge compression and inhibit migration of the interface material; wherein the metal cover preserves the interface material such that the interface material is durable during repeated sliding insertion and removal cycles and such that a heat transfer path is maintained through the metal cover, the interface material, and into the heat-removal component.

Clause 31. A device comprising: a heat sink having sockets along sidewalls of a pedestal; a thermal management assembly according to clause 30 engaged to the heat sink by receipt of the dimples along spaced-apart spring fingers of the metal cover into the sockets along the sidewalls of the pedestal; and a heat source configured to be slid into and out of thermal contact with the outer sliding surface of the metal cover; wherein the metal cover preserves the interface material during repeated sliding insertion and removal cycles and maintains a thermal path from the heat source through the metal cover and the interface material into the heat sink.

Example embodiments are provided so that this disclosure will be thorough and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific numerical dimensions and values, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (the disclosure of a first value and a second value for a given parameter may be interpreted as disclosing that any value between the first and second values could also be employed for the given parameter). For example, if Parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping, or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. As used herein, the singular forms "a", "an" and "the" may be intended to include the plural forms as well, unless the context clearly indicates otherwise. The terms "comprises," "comprising," "includes," "including," "has," "have," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on", "engaged to", "connected to" or "coupled to" another element or layer, it may be directly on, engaged, connected, or coupled to the other element or layer, or intervening elements or layers may be present. In contrast, when an element is referred to as being "directly on," "directly engaged to", "directly connected to" or "directly coupled to" another element or layer, there may be no intervening elements or layers present. Other words used to describe the relationship between elements should be interpreted in a like fashion (*e.g*., "between" versus "directly between," "adjacent" versus "directly adjacent," *etc*.). As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally", "about", and "substantially" may be used herein to mean within manufacturing tolerances.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer, or section. Terms such as "first," "second," and other numerical terms when used herein do not imply a sequence or order unless clearly indicated by the context. Thus, a first element, component, region, layer, or section could be termed a second element, component, region, layer, or section without departing from the teachings of the example embodiments.

Spatially relative terms, such as "inner," "outer," "beneath", "below", "lower", "above", "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" may encompass both an orientation of above and below. The device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and may be used in a selected embodiment, even if not specifically shown or described. The same may also be varied in many ways. Such variations are not to be regarded as a departure from the disclosure, and all such modifications are intended to be included within the scope of the disclosure.

## Claims

1. A thermal management assembly for sliding applications, the assembly comprising:
a substrate having opposite inner and outer surfaces; and
an interface material along the inner surface of the substrate;
wherein the substrate defines a durable layer that is disposed over and/or along the interface material and that is configured to contact a first surface of a first component when the thermal management assembly is along a second surface of a second component and when the first surface is slidably moved relative to the second surface.

2. The assembly of claim 1, wherein:
the substrate comprises a metal cover having an outer sliding surface and an inner surface;
the interface material is disposed on the inner surface of the metal cover;
a plurality of inwardly protruding dimples are along spaced-apart spring fingers of the metal cover, the dimples configured to be received in corresponding sockets of a heat-removal component; and
a heat transfer path extends through the metal cover, the interface material, and into the heat-removal component.

3. The assembly of claim 2, wherein first and second adhesive reinforcement strips are positioned on opposite edges of the interface material and extend along edges that are perpendicular to a sliding direction, whereby the interface material is confined between the first and second adhesive reinforcement strips such that, during sliding insertion of a heat source along the outer sliding surface of the metal cover, the first and second adhesive reinforcement strips absorb edge compression and inhibit migration of the interface material.

4. The assembly of claim 3, wherein:
the metal cover comprises stainless steel;
the interface material comprises a thermal phase-change material; and
each of the first and second adhesive reinforcement strips comprises a polymer film with pressure-sensitive adhesive on opposed sides.

5. The assembly of claim 3, wherein:
the metal cover comprises stainless steel having a thickness from 6 microns to 200 microns;
the interface material comprises a thermal phase-change material having a through-plane thermal conductivity from 0.15 Watts per meter per Kelvin (W/m-K) to 50 W/m-K; and
each of the first and second adhesive reinforcement strips comprises a polymer film with pressure-sensitive adhesive on opposed sides and has a total thickness not more than 200 microns.

6. The assembly of claim 2, wherein:
the metal cover comprises stainless steel having a thickness from 6 microns to 200 microns; and
the interface material comprises a thermal phase-change material having a through-plane thermal conductivity from 0.15 Watts per meter per Kelvin (W/m-K) to 50 W/m-K.

7. The assembly of any one of claims 2 to 6, wherein:
the metal cover has a thermal conductivity at least ten times greater than a polyimide film of equal thickness; and/or
the spring fingers are integral with sidewalls of the metal cover, and the sockets are notches in a pedestal of a heat sink.

8. The assembly of claim 1, wherein:
the substrate comprises self-locking features configured to interface and engage with corresponding self-locking features of a heat-removal component to thereby retain the substrate to the heat-removal component; or
the substrate includes protruding portions configured to be engagingly received within corresponding openings of a heat-removal component to thereby retain the substrate to the heat-removal component; or
the substrate comprises a plurality of openings configured to engagingly receive therein protruding portions of a heat-removal component to thereby retain the substrate to the heat-removal component.

9. The assembly of any one of the preceding claims, wherein:
the thickness of the interface material after burn-in is reduced by 10% to 40% relative to a pre burn-in thickness of the interface material; and/or
the substrate comprises a metal substrate including stainless steel, copper, or beryllium copper; and/or
a removable protective liner is disposed over the interface material with tear tabs aligned to a sliding direction.

10. The assembly of claim 1, wherein:
the durable layer has a higher thermal conductivity than polyimide film, and the durable layer has a wear-resistance and puncture resistance about the same as or better than polyimide film; and/or
the durable layer has a thickness within a range from 17.5 microns to 300 microns; and/or
the interface material has a thermal conductivity within a range from 1 W/m-K to 50 W/m-K.

11. The assembly of any one of the preceding claims, wherein:
the substrate comprises a metal substrate defining a metal wear-resistant layer that is disposed over and/or along the interface material and that is configured to slide along and in contact with the first surface of the first component when the thermal management assembly is along the second surface of the second component and when the first surface is slidably moved relative to the second surface; or
the substrate comprises a portion of an EMI cage for an optical transceiver application that defines the durable layer disposed over and/or along the interface material.

12. The assembly of any one of the preceding claims, wherein:
the interface material comprises at least one of: thermally-conductive pad, a thermally-conductive gap filler, a phase change thermal interface material, a dispensable thermal interface material, a thermal putty, and a thermal grease;
the substrate is configured to preserve the interface material during repeated sliding insertion and removal cycles of a heat source as the heat source slides in and out of position relative to the thermal management assembly, thereby maintaining a thermal path from the heat source, through the substrate and the interface material, and into a heat-removal component; and
the thermal management assembly is configured to improve heat transfer between the heat source and the heat-removal component via the substrate defining the durable layer over and/or along the interface material, thereby providing a durable, slide-resistant interface material with improved performance.

13. The assembly of any one of the preceding claims, wherein:
the first component comprises a heat source,
the second component comprises a heat sink;
the thermal management assembly is applied to the heat sink such that the interface material is between the heat sink and the durable layer and such that the durable layer is between the interface material and the heat source; and
the durable layer is configured to slide relatively along and in contact with the heat source when the heat source is slidably moved relative to the heat sink.

14. The assembly of any one of claims 1 to 12, wherein:
the first component comprises a heat sink;
the second component comprises a heat source; and
the thermal management assembly is applied to the heat source such that the interface material is between the heat source and the durable layer and such that the durable layer is between the interface material and the heat sink; and
the durable layer is configured to slide relatively along and in contact with the heat sink when the heat source is slidably moved relative to the heat sink.

15. An electronic device comprising:
a heat sink including a pedestal having sidewalls and sockets along the sidewalls of the pedestal;
a heat source; and
the thermal management assembly of any one of the preceding claims;
wherein:
the substrate comprises a metal cover having an outer sliding surface and an inner surface;
the interface material is disposed on the inner surface of the metal cover;
a plurality of inwardly protruding dimples are along spaced-apart spring fingers of the metal cover;
the thermal management assembly is engaged to the heat sink by receipt of the inwardly protruding dimples of the metal cover into the sockets along the sidewalls of the pedestal; and
the metal cover preserves the interface material during repeated sliding insertion and removal cycles of the heat source as the heat source is slid into and out of thermal contact with the outer sliding surface of the metal cover, thereby maintaining a thermal path from the heat source, through the metal cover and the interface material, and into the heat sink.
